# EUROPEAN PATENT SPECIFICATION

(11) **EP 1 448 867 B1**
(45) Date of publication and mention of the grant of the patent: **21.06.2006**
(21) Application number: 02787829.7
(22) Date of filing: 26.11.2002
(51) Int. Cl.: E21B 41/00

(54) **THERMOACOUSTIC ELECTRIC POWER GENERATION**
THERMOAKUSTISCHE ELEKTRIZITÄTSERZEUGUNG
PRODUCTION D'ENERGIE ELECTRIQUE THERMOACOUSTIQUE

(30) Priority: 26.11.2001 EP 01309911
(43) Date of publication of application: 25.08.2004
(73) Proprietor: SHELL INTERNATIONALE RESEARCH MAATSCHAPPIJ B.V., 2596 HR Den Haag (NL)
(72) Inventor: VAN DER SPEK, Alexander, Michael, NL-2288 GD Rijswijk (NL)
(86) International application number: PCT/EP2002/013315
(87) International publication number: WO 2003/046333

(56) References cited:
- WO-A-01/55551
- GB-A- 2 336 943
- US-A- 4 625 517
- US-A- 5 456 082
- US-A- 6 011 346

## Description

The invention relates to an electric power generator and a method for generating electric power within or in the vicinity of a gas transportation conduit.

Gas transportation conduits may be located at remote locations, such as downhole in a gas production well or underwater and/or underground, or in areas without a secure electric power supply, such as offshore or in unpopulated areas.

It is known from US patent 6,150,601 to generate electricity in a gas production tubing downhole in a well by a thermoelectric device which is powered by a temperature gradient of the well, which gradient may be created by arranging a flow restriction in the production tubing in which the gas is expanded and cooled by adiabatic expansion. A disadvantage of the known system is that a flow restriction will reduce the amount of gas produced and that the gas is cooled off only a few degrees Celsius unless the flow restriction is large and very high, e.g. ultrasonic, gas velocities are reached in a venturi, in which case the venturi will create a large flow restriction and be subject to a high wear rate.

US patent 6,011,346 discloses another downhole power generator, which comprises piezoelectric member, which is deformed by a pressure differential in a venturi. A disadvantage of this known power generator is that piezoelectric members have a low power output so that its efficiency is low.

It is an object of the present invention to alleviate the disadvantages of the known power generating systems and to provide a thermoacoustic power generator which has a higher efficiency than the known generators and which does not require the use of a flow restriction in the transportation conduit.

### SUMMARY OF THE INVENTION

The method according to the invention comprises:
- inducing a gas that flows through the gas transportation conduit to flow along an inlet of an acoustic resonance cavity thereby creating a standing acoustic wave in the resonance cavity, inducing the fluid in the cavity to flow through a permeable body in which a number of substantially stationary cold spots and/or hot spots are formed as a result of adiabatic expansion or comprising of the resonating fluid; and
- thermally connecting a thermoelectric device to at least one of said cold spots and/or hot spots to generate electrical power.

The permeable body may comprise a series of stacked plates, which are spaced at predetermined spacings from each other.

It is observed that US patents 4,625,517 and 5,456,082 disclose thermoacoustic devices with permeable bodies formed by an array of rods or plates that may be used in the method and generator according to the invention.

The thermoelectric device may comprise a thermocouple, which may form part of a Peltier element.

Furthermore an array of acoustic signal transducers may be arranged in or adjacent to the gas transportation conduit, which transducers detect characteristics of a standing acoustic wave in the gas transportation conduit emitted from the inlet of the acoustic resonance device. The acoustic transducers may be microphones which convert phase differences of the acoustic signal at different distances from said inlet into an electric, fibre optical or other signal, that is transmitted to a flow monitoring system which converts the measured phase difference(s) and/or other characteristics of the acoustic signal(s) into an indication of the gas flow velocity in the gas transportation conduit.

Suitably, the microphones are powered by the electricity generated by the thermoelectric device and transform the acoustic signal into a pulsed digital acoustical, optical, electrical or other signal. The flow monitoring system may be connected to a flow control assembly, which adjusts the gas flow rate in the transportation conduit in response to deviation of the monitored gas velocity from a reference value.

The invention also relates to a thermoelectric power generator for generating electrical power within or in the vicinity of a gas transportation conduit. The power generator according to the invention comprises an acoustic resonance cavity having an inlet which is connectable to an opening in the wall of a gas transportation conduit or of equipment, such as a robotic device, logging tool or inspection and/or cleaning tool arranged within the conduit, a permeable body in the acoustic resonance tube which is in use at least partly cooled off or heated as a result of adiabatic expansion or compression of the resonating fluid and a thermoelectric device which is connectable to at least one cold spot and/or hot spot formed in use in the permeable body for generating electrical power. DESCRIPTION OF A PREFERRED EMBODIMENT

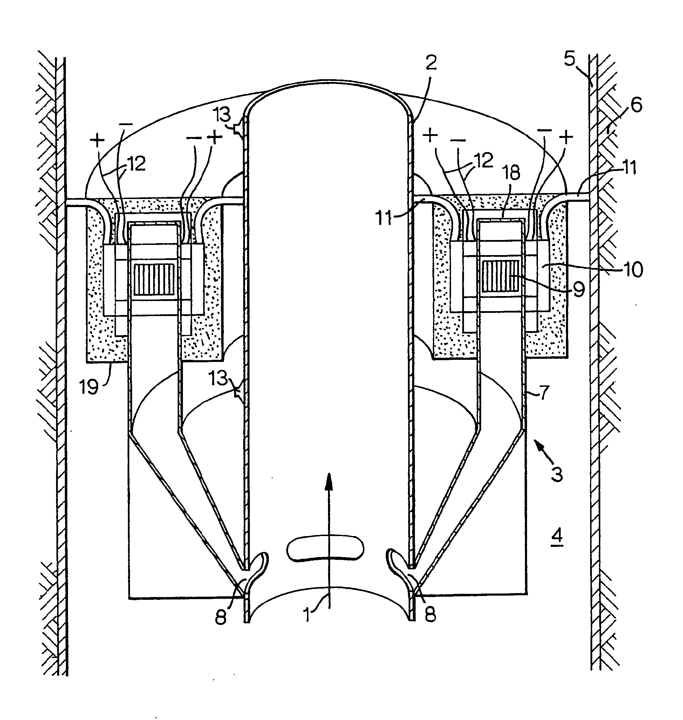

The invention will be described in more detail with reference to Fig.1, which depicts a schematic longitudinal sectional view of a production tubing in a gas well which is equipped with a thermoacoustic power generator according to the invention.

In Fig.1 a stream of natural gas 1 flows up through a production tubing 2 to a wellhead (not shown) at the earth surface. A thermoacoustic electric power generator 3 is arranged in the annular space 4 between the production tubing 2 and a well casing 5, which is cemented in an underground formation 6.

The power generator 3 comprises an annular acoustic resonance cavity 7, which has one or more inlet openings 8 which are formed by orifices or rings in the wall of the production tubing 2. The annular resonance cavity 7 has a closed top 18 and a permeable body 9 is mounted within the resonance cavity 7 near the top 18.

An annular thermoelectric converter 10 is mounted adjacent to the permeable body 9. The converter 10 is formed by a Peltier element 11 comprising bimetallic or semiconductor electrocouples which generate electric power as a result of the temperature difference between permeable body 9 and other components of the well caused by the cooling of the permeable body as a result of adiabatic expansion of the gas in the resonance cavity 7 caused by the resonating acoustic wave in the cavity 7. The heat sink of the permeable body 9 may be more than 50 °C. The cooled side of the Peltier element 10 is thus exposed to the heat sink of the permeable body and the other, hot, side of the Peltier element may be equipped with thermal conductors 11 which create a thermal bridge with adjacent uncooled components such as the wall of the production tubing 2 and the well casing 5. The upper end of the acoustic resonance cavity 7 and Peltier element 10 are encased in a protective and thermally insulating envelope 19.

The electrical cables 12 extend through the envelope 19 and are connected to a power conditioner and/or rechargeable battery and/or electrically powered downhole equipment (not shown), such as a gas flow monitoring and/or control system.

Suitably an array of microphones 13 is arranged in the production tubing 2 to detect the frequency and phase of the acoustic wave in the production tubing 2, which phase is related to the velocity of the gas stream 1 in the production tubing 2. Thus the signal generated by the microphones 13 may be transmitted to a flow monitoring device which converts the detected frequency into a gas velocity indication. The flow monitoring device may be located at the earth surface and the signal generated by the microphone may be transmitted to surface by an electric or fibre optical cable or as an amplified acoustic signal or as an electromagnetic signal which is transmitted via the wall of the production tubing 2.

It will be understood that the thermoacoustic power generator 3 may also be applied in conjunction with gas transportation conduits at or near the earth surface, such as subsea gas transportation pipelines and pipelines in remote areas, such as polar regions and deserts where there is no adequate electrical power supply-to provide electrical power to necessary flow monitoring and control equipment.

Furthermore the thermoacoustic power generator according to the invention may be used to provide electrical power to equipment which is used within a gas transportation conduit or well, such as a robotic device, a well logging tool or an internal pipe inspection and/or cleaning tool. In such case the acoustic resonance cavity may be formed within the equipment housing and the inlet of the cavity is formed by one or more openings formed in the wall of the equipment housing, whereas a gas stream flows around the housing and initiates a standing acoustic wave within the acoustic resonance cavity.

In an alternative embodiment the thermoacoustic power generator according to the invention may operate as a heat pump and may be connected to a hot spot formed in the permeable body as a result of an adiabatic compression of the fluid resulting from the resonating acoustic wave pattern within the acoustic resonance cavity. The thermoelectric device may be coupled between one or more cold spots and one or more hot spots formed in the permeable body as a result of the thermal effects resulting from the resonating acoustic wave pattern.

## Claims

1. A method of generating power within or in the vicinity of a gas transportation conduit, (2) the method comprising:
- inducing a gas (1) that flows through the gas transportation conduit (2) to flow along an inlet (8) of an acoustic resonance cavity (7) thereby creating a standing acoustic wave in the resonance cavity (7), inducing the fluid in the cavity to flow through a permeable body (9) in which a number of substantially stationary cold spots and/or hot spots are formed as a result of adiabatic expansion or compression of the resonating fluid; and
- thermally connecting a thermoelectric device (10) to at least one of said cold spots and/or hot spots to generate electrical power.

2. The method of claim 1, wherein the resonance cavity has an annular shape and is arranged downhole around a production tubing in a gas production well.

3. The method of claim 1, wherein the gas transportation conduit is a gas transport pipeline at a remote location, such as underwater and/or underground or in an area without electric power supply facilities.

4. The method of claim 1, 2 or 3, wherein the permeable body comprises a series of stacked plates, which are spaced at predetermined spacings from each other.

5. The method of claims 2 and 4, wherein the stacked plates are formed in the annular resonance cavity by coiling a strip around the inner wall of the annular resonance tube and by arranging a series of spacers between the adjacent layers of the coiled strip.

6. The method of any one of claims 1-5, wherein the thermoelectric device comprises a thermocouple which is connected between a hot spot and a cold spot of the permeable body or between a hot or cold spot of the permeable body and a component of which the temperature is substantially unaffected by the standing acoustic waves.

7. The method of claim 6, wherein the thermocouple forms part of a Peltier element.

8. The method of any preceding claim, wherein an array of acoustic signal transducers is arranged in or adjacent to the gas transportation conduit, which transducers detect characteristics of an acoustic wave in the gas transportation conduit emitted from the inlet of the acoustic resonance cavity.

9. The method of claim 8, wherein the acoustic transducers comprises microphones which convert the acoustic signal into an electric, fibre optical or other signal, which is transmitted to a flow monitoring assembly which converts phase differences and/or other characteristics of the acoustic signals into an indication of the gas flow velocity in the gas transportation conduit.

10. The method of claim 9, wherein the microphones are powered by the electricity generated by the thermoelectric cavity and transform the acoustic signal into a pulsed digital acoustical, optical, electrical or other signal.

11. The method of claim 8, wherein the signal transducers comprise one or more rechargeable batteries, which are charged by the thermoelectric device.

12. The method of claim 9, wherein the flow monitoring system is connected to a flow control assembly which adjusts the gas flow rate in the transportation conduit in response to deviation of the monitored gas velocity from a reference value.

13. A thermoelectric power generator(3) for generating electrical power within or in the vicinity of a gas transportation conduit (2), comprising:
- an acoustic resonance cavity (7) having an inlet which is connectable to an opening (8) in the wall of a gas transportation conduit (2) or of equipment arranged within the conduit (2);
- a permeable body (9) in the acoustic resonance cavity (7) which is in use at least partly cooled off or heated as a result of adiabatic expansion or compression of the resonating fluid; and a thermoelectric device (10) which is connectable to at least one cold spot and/or hot spot formed in use in the permeable body (9) for generating electrical power.

## Patentansprüche

1. Verfahren zum Erzeugen von Energie innerhalb oder in der Nähe einer Gastransportleitung (2), wobei das Verfahren umfaßt:
- Induzieren eines Gases (1), das durch die Gastransportleitung (2) strömt, derart, daß es entlang eines Einlasses (8) eines akustischen Resonanzhohlraumes strömt, wodurch in dem Resonanzhohlraum (7) eine stehende akustische Welle erzeugt wird, Induzieren des Fluids in dem Hohlraum, derart, daß es durch einen permeablen Körper (9) strömt, in welchem eine Anzahl von im wesentlichen stationären kalten Stellen und/oder heißen Stellen infolge einer adiabatischen Expansion oder Kompression des Resonanzfluids gebildet werden; und
- thermisches Verbinden einer thermoelektrischen Vorrichtung (10) mit zumindest einer der kalten Stellen und/oder heißen Stellen zur Erzeugung von elektrischer Energie.

2. Verfahren nach Anspruch 1, bei welchem der Resonanzhohlraum ringförmige Gestalt hat und in einem Bohrloch um ein Förderrohr eines Gasförderschachtes herum angeordnet ist.

3. Verfahren nach Anspruch 1, bei welchem die Gastransportleitung eine Gastransport-Pipeline an einem entfernten Ort, wie unter Wasser und/oder unter Grund oder in einer Gegend ohne elektrische Energiezufuhreinrichtungen, ist.

4. Verfahren nach Anspruch 1, 2 oder 3, bei welchem der permeable Körper eine Reihe von gestapelten Platten umfaßt, die mit vorbestimmten Abständen zueinander angeordnet sind.

5. Verfahren nach Anspruch 2 und 4, bei welchem die gestapelten Platten in dem ringförmigen Resonanzhohlraum durch Wickeln eines Streifens um die Innenwand des ringförmigen Resonanzrohres und durch Anordnung einer Reihe von Abstandhaltern zwischen benachbarten Schichten des gewickelten Streifens gebildet werden.

6. Verfahren nach einem der Ansprüche 1 bis 5, bei welchem die thermoelektrische Vorrichtung ein Thermoelement aufweist, das zwischen einer heißen Stelle und einer kalten Stelle des permeablen Körpers oder zwischen einer heißen oder kalten Stelle des permeablen Körpers und einer Komponente angeordnet ist, deren Temperatur von den stehenden akustischen Wellen im wesentlichen unberührt bleibt.

7. Verfahren nach Anspruch 6, bei welchem das Thermoelement Teil eines Peltier-Elementes bildet.

8. Verfahren nach einem der vorhergehenden Ansprüche, bei welchem eine Reihe von akustischen Signalwandlern in oder nahe der Gastransportleitung angeordnet ist, wobei die Wandler die Eigenschaften einer akustischen Welle in der Gastransportleitung feststellen, die von dem Einlaß des akustischen Resonanzhohlraumes emittiert wird.

9. Verfahren nach Anspruch 8, bei welchem die akustischen Wandler Mikrofone aufweisen, welche das akustische Signal in ein elektrisches, faseroptisches oder anderes Signal umwandeln, das zu einer Strömungsüberwachungsanordnung übertragen wird, welche die Phasendifferenzen und/oder andere Eigenschaften der akustischen Signale in eine Anzeige der Gasströmungsgeschwindigkeit in der Gastransportleitung umwandeln.

10. Verfahren nach Anspruch 9, bei welchem die Mikrofone mit Elektrizität versorgt werden, die von dem thermoelektrischen Hohlraum erzeugt wird, und das akustische Signal in ein gepulstes, digitales, akustisches, optisches, elektrisches oder anderes Signal transformieren.

11. Verfahren nach Anspruch 8, bei welchem die Signalwandler eine oder mehrere wiederaufladbare Batterien umfassen, die von der thermoelektrischen Vorrichtung aufgeladen werden.

12. Verfahren nach Anspruch 9, bei welchem das Strömungsüberwachungssystem mit einer Strömungssteuerungsanordnung verbunden ist, welche die Gasströmungsrate der Transportleitung in Abhängigkeit von der Abweichung der überwachten Gasströmungsgeschwindigkeit von einem Referenzwert einstellt.

13. Thermoelektrischer Energieerzeuger (3) zur Erzeugung von elektrischer Energie innerhalb oder in der Nähe einer Gastransportleitung (2), umfassend:
- einen akustischen Resonanzhohlraum (7) mit einem Einlaß, der mit einer Öffnung (8) in der Wand einer Gastransportleitung (2) oder einer Ausrüstung in Verbindung steht, die innerhalb der Leitung (2) angeordnet ist;
- einen permeablen Körper (9) in dem akustischen Resonanzhohlraum (7), der im Betrieb zumindest teilweise infolge der adiabatischen Expansion oder Kompression des Resonanzfluids gekühlt oder erhitzt wird; und eine thermoelektrische Vorrichtung (10), die mit zumindest einer kalten Stelle und/oder einer heißen Stelle in Verbindung versetzbar ist, die im Betrieb in dem permeablen Körper (9) zur Erzeugung von elektrischer Energie geformt werden.

## Revendications

1. Procédé de création d'énergie dans un conduit (2) de transport de gaz ou au voisinage de ce dernier, le procédé comprenant les étapes qui consistent à :
- induire un gaz (1) qui s'écoule dans le conduit (2) de transport de gaz à s'écouler le long de l'entrée (8) d'une cavité de résonance acoustique (7) en créant ainsi dans la cavité de résonance une onde acoustique stationnaire qui induit le fluide présent dans la cavité à s'écouler à travers un corps perméable (9) dans lequel un certain nombre de points froids et/ou de points chauds essentiellement stationnaires se forme suite à la détente ou à la compression adiabatique du fluide en résonance et
- relier thermiquement un dispositif thermoélectrique (10) à au moins l'un desdits points froids et/ou desdits points chauds pour créer de l'énergie électrique.

2. Procédé selon la revendication 1, dans lequel la cavité de résonance présente une forme annulaire et est agencée en fond de puits autour d'un tube de production dans un puits de production de gaz.

3. Procédé selon la revendication 1, dans lequel le conduit de transport de gaz est un conduit de transport de gaz situé à distance, par exemple un conduit sous-marin et/ou souterrain et/ou situé dans une zone qui ne dispose pas d'installations de fourniture d'énergie électrique.

4. Procédé selon les revendications 1, 2 ou 3, dans lequel le corps perméable comprend une série de plaques empilées qui sont espacées les unes des autres à des intervalles prédéterminés.

5. Procédé selon les revendications 2 et 4, dans lequel les plateaux empilés sont formés dans la cavité annulaire de résonance en enroulant une bande autour de la paroi intérieure du tube annulaire de résonance et en agençant une série d'écarteurs entre des couches adjacentes de la bande enroulée.

6. Procédé selon l'une quelconque des revendications 1 à 5, dans lequel le dispositif thermoélectrique comprend un thermocouple qui relie un point chaud et un point froid du corps perméable ou un point chaud ou froid du corps perméable et un composant dont la température reste essentiellement non affectée par les ondes acoustiques stationnaires.

7. Procédé selon la revendication 6, dans lequel le thermocouple fait partie d'un élément Peltier.

8. Procédé selon l'une quelconque des revendications précédentes, dans lequel une série de transducteurs de signaux acoustiques est agencée dans le conduit de transport du gaz ou en position adjacente à ce dernier, lequel transducteur détecte les caractéristiques de l'onde acoustique émise dans le conduit de transport de gaz par l'entrée de la cavité de résonance acoustique.

9. Procédé selon la revendication 8, dans lequel les transducteurs acoustiques comprennent des microphones qui convertissent le signal acoustique en un signal électrique, un signal pour fibres optiques ou un autre signal qui est transmis à un ensemble de surveillance de l'écoulement qui convertit les différences de phases et/ou les caractéristiques des signaux acoustiques en une indication de la vitesse d'écoulement du gaz dans le conduit de transport de gaz.

10. Procédé selon la revendication 9, dans lequel les microphones sont alimentés par électricité créée par la cavité thermoélectrique et transforment le signal acoustique en un signal numérique pulsé, un signal acoustique, un signal optique, un signal électrique ou un autre signal.

11. Procédé selon la revendication 8, dans lequel les transducteurs de signaux présentent une ou plusieurs batteries rechargeables qui sont chargées par le dispositif thermoélectrique.

12. Procédé selon la revendication 9, dans lequel le système de surveillance de l'écoulement est relié à un ensemble de contrôle de l'écoulement qui ajuste le débit de gaz dans le conduit de transport en réponse à des écarts entre la vitesse du gaz mesurée et une valeur de référence.

13. Générateur d'énergie thermoélectrique (3) qui crée de l'énergie électrique dans un conduit (2) de transport de gaz ou au voisinage de ce dernier et qui comprend:
- une cavité de résonance acoustique (7) dotée d'une entrée qui peut être reliée à une ouverture (8) ménagée dans la paroi d'un conduit (2) de transport de gaz ou à un équipement agencé dans le conduit (2),
- un corps perméable (9) placé dans la cavité de résonance acoustique (7) et qui, en utilisation, est au moins en partie refroidi ou chauffé suite à la détente ou à la compression adiabatiques du fluide en résonance, et un dispositif thermoélectrique (10) qui peut être relié à au moins un point froid et/ou un point chaud formé en utilisation dans le corps perméable (9), pour créer de l'énergie électrique.
